(19) Europäisches Patentamt

European Patent Office

Office européen des brevets

(11) Veröffentlichungsnummer: **0 480 273 A1**

## (12) EUROPÄISCHE PATENTANMELDUNG

(21) Anmeldenummer: **91116624.7**

(22) Anmeldetag: **30.09.91**

(51) Int. Cl.⁵: **H05H 1/46**

(30) Priorität: **06.10.90 DE 9013937 U**

(43) Veröffentlichungstag der Anmeldung:
**15.04.92 Patentblatt 92/16**

(84) Benannte Vertragsstaaten:
**AT BE CH DE DK ES FR GB IT LI NL SE**

(71) Anmelder: **RÖHM GMBH
Kirschenallee
W-6100 Darmstadt(DE)**

(72) Erfinder: **Heinemann, Michael
Im Schöll 30/32
W-6115 Münster(DE)**
Erfinder: **Söder, Bernhard, Dr.
Wilhelm-Leuschner-Strasse 11
W-6104 Seeheim-Jugenheim(DE)**

(54) **Mikrowellenstrahler.**

(57) Ein Mikrowellenstrahler, enthaltend eine Mikrowellen-Strahlungsquelle und einen Mikrowellen-hohlleiter (14) aus Metall, der mit einem Dielektrikum gefüllt ist und ein Fenster (7) mit einer Längenausdehnung von mehreren Wellenlängen für den Austritt der Mikrowellen-Strahlung aufweist.

Mittels eines verstellbaren Wandabschnittes (11) aus Metall kann der Hohlleiterquerschnitt stetig verkleinert werden um ein genau lokalisiertes und sehr homogenes Mikrowellen-Strahlungsfeld zu erzeugen.

Fig. 4

Die Erfindung betrifft einen Mikrowellenstrahler zur Erzeugung eines Strahlungsfeldes mit einer Längenausdehnung von mehreren Wellenlängen, insbesondere zur Bildung eines homogenen Niederdruck-Plasmas. Als Strahlungsfeld wird der Flächenbereich bezeichnet, in welchem die Mikrowellenstrahlung austritt.

Stand der Technik

Aus der EP-A 335 675 ist ein Mikrowellenstrahler zur Erzeugung eines homogenen Plasmas über eine Längenausdehnung von mehreren Wellenlängen bekannt. Er enthält eine Mikrowellen-Strahlungsquelle, einen Mikrowellenhohlleiter aus Metall und ein Fenster mit einer Längenausdehnung von mehreren Wellenlängen für den Austritt der Mikrowellen-Strahlung aus dem Hohlleiter. Um die aus dem Hohlleiter austretende Mikrowellenstrahlung auf eine möglichst große Strahlungsfläche zu verteilen, kann die Austrittsöffnung für die Strahlung in eine Reihe von einzelnen Öffnungen aufgeteilt werden oder ihre Breite mit zunehmender Entfernung von der Strahlungsquelle größer werden. Beide Anordnungen erzeugen keine hinreichend gleichmäßige Strahlung. Um dennoch ein gleichmäßiges Plasma zu erzeugen, wird in einem ziemlich großen Abstand von der Austrittsöffnung eine für Mikrowellen durchlässige Trennwand vorgesehen, die z.B. in Form eines Zylinders oder Halbzylinders aus Quarzglas gestaltet ist. Innerhalb der Trennwand befindet sich Luft unter einem Druck, bei dem sich kein Plasma bildet. Wegen des großen Abstandes der Trennwand von der Austrittsöffnung hat der Strahler eine erhebliche Größe, die eine noch wesentlich größere Vakuum-Vorrichtung zur Erzeugung des Plasmas erforderlich macht. Das Plasma kann auf diese Weise nicht so lokalisiert und begrenzt werden, wie z.B. für die Behandlung eines kontinuierlich durchlaufenden Substrats wünschenswert wäre.

Ein anderes Prinzip zur Verteilung einer Mikrowellenstrahlung auf eine größere Breite ist aus DE-A 31 47 986 bekannt. Die Strahlung wird auf einen Oberflächenwellenleiter geführt, von dem sie durch ein strahlungsdurchlässiges Fenster in eine Vakuumkammer eingestrahlt wird. Um eine gleichmäßige Strahlung zu erreichen, werden mehrere Strahlungsquellen und Oberflächenwellenleiter benötigt.

Aufgabe und Lösung

Der Erfindung liegt die Aufgabe zugrunde, den Mikrowellenstrahler möglichst klein zu gestalten und eine genauere Lokalisierung und Begrenzung des Strahlungsfeldes bei hoher Homogenität über eine Ausdehnung von mehreren Wellenlängen zu erreichen.

Ausgangspunkt der Erfindung ist ein Mikrowellenstrahler, enthaltend eine Mikrowellen-Strahlungsquelle und einen Mikrowellenhohlleiter aus Metall, der mit einem Dielektrikum gefüllt ist und ein Fenster mit einer Längenausdehnung von mehreren Wellenlängen für den Austritt der Mikrowellen-Strahlung aufweist.

Erfindungsgemäß nimmt der das Dielektrikum umschließende Querschnitt des Hohlleiters bzw. das Dielektrikum im Bereich des Fensters mit zunehmender Entfernung von der Mikrowellen-Strahlungsquelle stetig ab und/oder die Dielektrizitätskonstante des Dielektrikums zu.

Zur Erläuterung der Erfindung dienen die Figuren 1 bis 6.

**Figur 1** zeigt schematisch einen Längsschnitt durch das Dielektrikum bzw. den Hohlleiter senkrecht zur Ebene des Austrittsfensters.

**Figur 2** zeigt schematisch den Wellenverlauf innerhalb des Strahlers.

**Figur 3** stellt eine andere Ausführungsform des Strahlers mit Blick auf das Austrittsfenster schematisch dar.

**Figur 4** stellt einen Schnitt durch eine erfindungsgemäße Plasmabeschichtungsvorrichtung dar.

**Figur 5** zeigt in perspektivischer Ansicht einen erfindungsgemäßen Strahler, wie in der Vorrichtung gemäß Fig.4 enthalten.

**Figur 6** zeigt eine Ausführungsform des in Fig. 2 schematisch dargestellten Strahlers.

Wirkungen und Vorteile der Erfindung

Der abnehmende Querschnitt im Bereich des Austrittsfensters hat die Wirkung, daß die Feldstärke innerhalb des Dielektrikums trotz der Abstrahlung der Mikrowellenstrahlung durch das Austrittsfenster über seine ganze Länge im wesentlichen konstant bleibt. Zu diesem Zweck wird die Abnahme des Querschnittes so bemessen, daß die Auswirkung der abgestrahlten Leistung auf die Feldstärke über die Länge des Austrittsfensters gerade kompensiert wird.

Wenn das Dielektrikum gasförmig ist, wird es durch die Wände des Hohlleiters begrenzt; in diesem Fall ist der Querschnitt des Hohlleiters mit dem des Dielektrikums identisch. Wird dagegen ein Festkörper als Dielektrikum verwendet, so genügt es, daß dessen Querschnitt abnimmt, während der Querschnitt des Hohlleiters im Bereich des Austrittsfensters gegebenenfalls gleich bleiben kann.

Die gleiche Wirkung wie eine Querschnittsabnahme hat eine stetige Zunahme der Dielektrizitätskonstante. Gegebenenfalls können beide Effekte miteinander kombiniert werden. Da Werkstoffe mit stetig zunehmender Dielektrizitätskonstante schwer zugänglich sind, hat diese Ausführungsform der Erfindung geringere praktische Bedeutung.

Der erfindungsgemäße Mikrowellenstrahler läßt eine kompakte Bauweise einer Plasmabehandlungs-Vorrichtung zu, da bereits aus dem Hohlleiter eine sehr gleichmäßige Strahlung austritt und die Bildung eines homogenen, begrenzten und genau lokalisierten Plasmas zuläßt. Das im Plasma zu behandelnde Substrat kann unmittelbar vor dem Austrittsfenster des Hohlleiters angeordnet oder kontinuierlich vorbeigeführt werden.

Mittels des neuen Mikrowellenstrahlers lassen sich in einem Niederdruckplasma sehr dünne Schichten erzeugen, die aufgrund ihrer hohen Gleichmäßigkeit auch auf transparenten Substraten keine Newton'schen Ringe oder ähnliche störende Interferenzerscheinungen ergeben.

Anwendung des Mikrowellenstrahlers

Der neue Mikrowellenstrahler eignet sich für alle typischen Anwendungen derartiger Strahler, beispielsweise zum Erwärmen von Mikrowellen absorbierenden Substraten. Vorzugsweise dient die Erfindung jedoch zur Erzeugung von Niederdruckplasmen, insbesondere zum Beschichten von flächigen Substraten. Solche Beschichtungen können in an sich bekannter Weise z.B. durch schichtbildende Gase und Dämpfe, wie Silane oder Kohlenwasserstoffe, unter Plasmaeinwirkung mit hohen Depositionsraten von etwa 1 Mikrometer pro Minute gebildet werden.

Theoretische Grundlagen der Erfindung

Wesentliche Ursachen der Inhomogenität von Mikrowellen-Plasmen sind stehende Wellen, die sich durch Reflexion der Hochfrequenz bilden. Dementsprechend müssen bei der Konstruktion von Mikrowellenstrahlern reflektierende elektrische Stoßstellen möglichst vermieden werden. Während dies theoretisch durch eine unendliche, longitudinale Ausdehnung der Mikrowellenstrahlung möglich ist, bietet sich für die Praxis hierfür ein dem Wellenwiderstand äquivalenter Absorber am Antennenende an.

Die Restwelligkeit der Hochfrequenz auch eines angepaßt, d.h. reflexionsfrei, abgeschlossenen Hohlleiters bildet im Plasma Inhomogenitäten aus, deren Periode durch die Mikrowellenlänge bestimmt ist. Aufgrund einer gewissen Volumenausdehnung des Plasmas, abhängig von Druck und Leistung, nimmt dessen Homogenität durch Diffusion zwischen benachbarten Wellenbergen mit abnehmenden Abständen zwischen den Maxima zu.

Die Wellenlänge kann um den Faktor 1/sqr(ER) verkürzt werden, wenn ein geeignetes Dielektrikum mit der relativen Dielektrizitätskonstante 'ER'in das elektromagnetische Feld eingebracht wird.

Es existieren auf dem Markt Materialien, wie z.B. Keramiken, deren Wert für 'ER' weit über 10 liegt und die noch niedrige Verlustfaktoren bei Gigahertz-Frequenzen aufweisen. Für die häufig verwendete Frequenz von 2,45 GHz wird in einem Rechteckhohlleiter von 86 mm x 86 mm durch eine Füllung mit einem Dielektrikum von ER = 20 die Wellenlänge von 122,5 mm auf 27,4 mm verkürzt.

Wie bereits beschrieben, ist die räumliche Ausdehnung des Plasmas mitunter eine Funktion der Leistung P, die sich wellenförmig entlang des Strahlers verteilt. Wird der Plasmaraum derart eingeengt, daß bei gegebener Leistung das theoretisch beanspruchte Volumen größer ist als das real vorhandene, tritt durch einen Konkurrenzeffekt zwischen Elektronenaufheizung und Ausdehnung eine Plasmaverbreiterung parallel zur Strahleroberfläche auf. Räumlich bedeutet dies eine gegenseitige Annäherung der Plasmagrenzflächen, was den Diffusionsausgleich effektiver gestaltet.

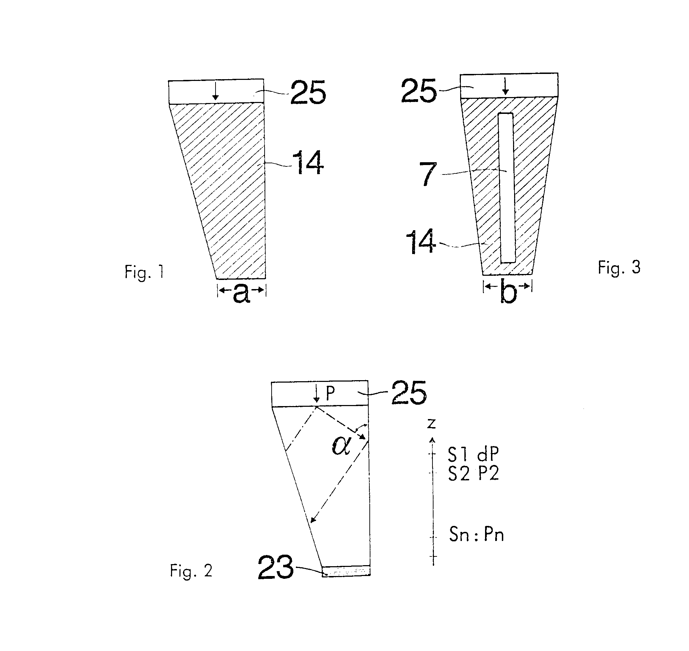

Da das Plasma vorzugsweise am Ort größter Feldstärke brennt, also am Einspeisungsort, muß eine gleichmäßige Leistungsverteilung entlang des Strahlers vorliegen. Dies wird - wie in Fig.1 und 3 schematisch dargestellt - erfindungsgemäß durch die Formgebung des Strahlers, bzw. des Dielektrikums im Bereich des Fensters realisiert, da es - quasi-optisch betrachtet - gegenüber Luft bzw. Vakuum/Plasma sehr dicht ist und Ähnlichkeiten mit einem teildurchlässigen Spiegel aufweist. Wie in Fig.2 dargestellt, wird die auftreffende Wellenfront, deren Einfallswinkel A von ER, der Frequenz und der Strahlergeometrie abhängig ist, teilweise reflektiert und kann, vom Einspeisungsort weiter entfernt, zur Leistungsbilanz beitragen.

Eine weitere Maßnahme zur Plasmahomogenisierung geschieht erfindungsgemäß durch Einflußnahme auf den Feldstärkeverlauf.

Die am Ort S1 (Fig.2) zur Verfügung stehende Leistung $P_{gesamt}$ reduziert sich um die im Bereich zwischen S1 und S2 ausgekoppelte Leistung dP. Für den Ort P2 gilt demnach:

$$P2 = P_{gesamt} - dP$$

Weiterhin ist:

$$E = (P\mu_r^{\frac{1}{2}}ER^{-\frac{1}{2}}[1-\{\lambda_o(m^{\frac{1}{2}}a^{-\frac{1}{2}}+n^{\frac{1}{2}}b^{-\frac{1}{2}})\cdot\frac{1}{2}0,5\mu_r^{\frac{1}{2}}ER^{-\frac{1}{2}}\}2]^{\frac{1}{2}})^{\frac{1}{2}}$$

Darin bedeuten:

E = Feldstärke am Betrachtungsort im Hohlleiter am Fenster

m = Intervallfaktor Hohlleiter breitseitenbezogen (a)

mE z\0 in J = [m π|(m + l)π]

n = Intervallfaktor Hohlleiter schmalseitenbezogen (b)

$$nE z \text{ in } J = [n\pi|(n+l)\pi]$$

ER = relative Dielektrizitätskonstante
$\lambda_o$ = Vakuumwellenlänge
$\mu_r$ = relative magnetische Permeabilität
p = zur Verfügung stehende Mikrowellenleistung am Betrachtungsort im Hohlleiter am Fenster

Erfindungsgemäß wird eine sehr effektive Steuerung der Feldstärkeverteilung und somit des Plasmas durch eine vom üblichen Rechteck-Hohlleiter abweichende Form des Wellenleiters ermöglicht.

Die Berechnung der Wellenleiterform geschieht unter Berücksichtigung obengenannter Einflüsse und der Forderung, die Feldstärke an jedem Punkt entlang der konstant breiten Strahleröffnung gleich groß zu halten. Es hat sich in den meisten Fällen als ausreichend erwiesen, die Seiten a und/oder b (Fig. 1 bis Fig. 3) keilförmig zulaufend auszubilden, während die theoretisch exakte Form wesentlich komplizierter wäre. Zu berücksichtigen ist allerdings das Auftreten von Modensprüngen beim Unterschreiten gewisser Kantenlängen a und b, bzw. das Aussetzen der Wellenleitung unterhalb der Cut-Off-Wellenlänge.

Aufbau einer Niederdruckplasma-Beschichtungsanlage

Die Mikrowellenstrahlung geht von einer Strahlungsquelle üblicher Bauart mit einer Frequenz von 1 bis 15 GHz aus. Bevorzugt ist die Frequenz von 2,45 GHz, was einer Wellenlänge von 122,5 mm im Vakuum entspricht. Die Strahlung wird in herkömmlicher Weise an der Einspeisungsstelle 25 in einen Mikrowellenhohlleiter 14 aus Metall eingeleitet, der für eine Strahlung der oben angegebenen Art zweckmäßig einen rechteckigen Querschnitt von 43 x 86 mm (Innenmaße) hat.

Der Hohlleiter 14 ist bis zum Austrittsfenster 7 mit einem Dielektrikum von möglichst geringem Verlustfaktor gefüllt. Geeignete Dielektrika sind an sich bekannt; dazu gehören Gase mit einem Druck, bei dem keine Glimmentladung eintritt, d.h von mehr als 0,01 bar, sowie Kunststoffe oder keramische Werkstoffe von entsprechend geringem Verlustfaktor.

In Plasma-Beschichtungsanlagen ist bei Verwendung von gasförmigen oder flüssigen Dielektrika ein druckdichtes Austrittsfenster 7 zwischen dem Hohlleiter 14 und der Vakuumkammer 15 erforderlich. Es besteht aus einem für Mikrowellen hinreichend durchlässigen Werkstoff von ausreichender mechanischer Festigkeit, um dem gegebenenfalls auftretenden Druckunterschied standzuhalten. Geeignet sind Quarzglasscheiben und keramische Werkstoffe. Wird ein festes Dielektrikum, beispielsweise aus Kunststoff, verwendet, so kann dessen Außenseite zugleich als Austrittsfenster dienen.

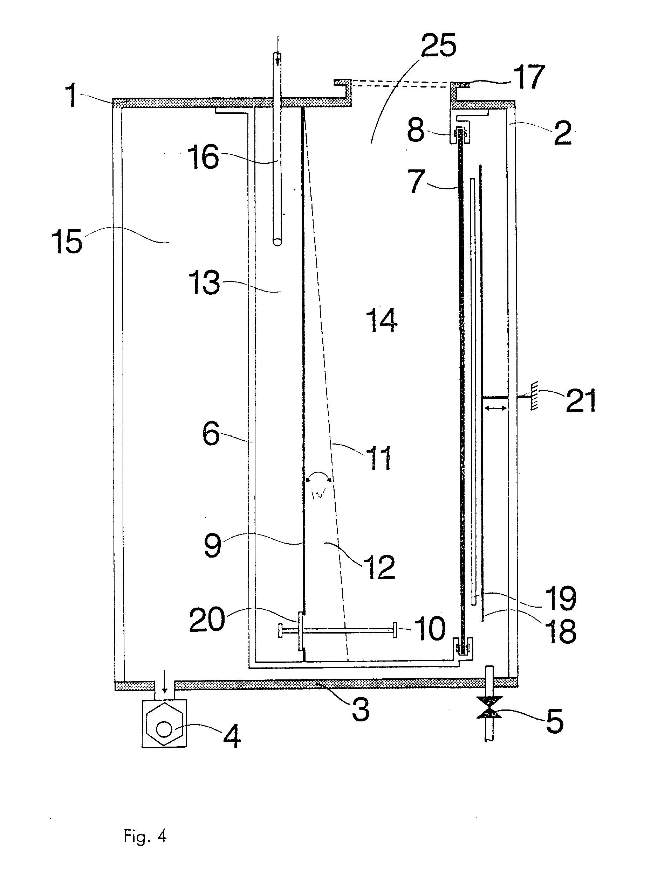

Aus Fig. 4 ist der prinzipielle Aufbau einer Plasmabeschichtungsanlage gemäß der Erfindung zu ersehen. Deckel 1, Wandung 2 und Boden 3 bilden die mittels der Pumpe 4 evakuierbare Vakuumkammer 15. Durch den Einlaß 5 kann ein zur Beschichtung dienendes Funktionsgas einströmen. Geeignete Funktionsgase sind z.B. Silane, wie Trimethoxymethylsilan, Siloxane, wie Hexamethyldisiloxan, Acrylate, wie Methylacrylat oder Methylmethacrylat, Sauerstoff oder Edelgase, wie Argon. Das gegenüber dem Austrittsfenster 7 angeordnete Substrat 19 und die dahinter befindliche Masse 18 begrenzen den Plasmabrennraum. Mit Hilfe des Gestänges 21 kann die Masse 18 und damit das daran anliegende Substrat 19 in eine zur Ausbildung des Plasmas günstige Stellung gebracht werden.

Zweckmäßig ist eine Wandung 2 in Form einer vakuumdicht verschließbaren Tür 22 ausgebildet, an der über das Gestänge 21 die Masse 18 und das daran angebrachte Substrat 19 befestigt sind. Durch Öffnen der belüfteten Vakuumkammer 15 kann das Substrat 19 eingebracht bzw. entnommen werden. Um ein bahnförmiges Substrat im kontinuierlichen Durchlauf zu beschichten, sind anstelle des Gestänges 21 und der Masse 19 geeignete Vorrichtungen erforderlich, um das Substrat mit gleichmäßiger, einstellbarer Geschwindigkeit durch das Plasma zu führen. Wenn sich Vorratsrollen des Substrats in der Vakuumkammer unterbringen lassen, werden sie so angeordnet, daß mittels einer motorisch angetriebenen Transportvorrichtung die Bahn von der einen Rolle abgewickelt, durch das Plasma geleitet und danach wieder aufgewickelt wird. Ist das Substrat nicht wickelbar oder für die Unterbringung in der Vakummkammer zu groß, so muß es zur kontinuierlichen Beschichtung durch zwei gasdichte Schleusen zu beiden Seiten des Plasmas ein- bzw. ausgeführt werden.

Die Hochfrequenzleistung wird über den Flansch 17 in den Hohlleiter eingekoppelt. Dessen Innenraum 14 ist entweder mit einem festen Dielektrikum oder mit einem als solches wirksamen Gas gefüllt.

Der Mikrowellenstrahler wird begrenzt durch die Wandung 6 und das Austrittsfenster 7, das aus einem aus wärme-und hochfrequenzbeständigen, als Dielektrikum wirkenden Werkstoff besteht, und ist mittels der Halterung 8 zu einer gasdichten und druckfesten Einheit verschraubt.

Durch die metallische Trennwand 9 ist der Strahler 6 in zwei Bereiche unterteilt, nämlich den vorderen Hohlleiter 14, dessen Funktion dem oben beschriebenen Prinzip entspricht, und den Absorberkanal 13, der die Dimension eines H10-Leiters besitzt. Die am Ende der Antenne ankommende Energie darf, um stehende Wellen zu vermeiden, nicht reflektiert werden. Deshalb wird sie mittels des Koppelgliedes 10 in den Kanal 13 umgeleitet, der zur Absorption der Reststrahlung mit einer elektrisch angepaßten Wasserlast 16 abgeschlossen ist. Das Koppelglied besteht aus Metall, beispielsweise aus Kupfer. Die Wasserlast 16 hat die Wirkung, daß sie die Mikrowellenstrahlung absorbiert. Sie kann aus einem wasserdurchströmten Glasrohr bestehen. Um auch beim Koppler 10 eine exakte Anpassung an die Impedanz zu ermöglichen, ist dieser justierbar mit Hilfe der Halterung 20 aus hochfrequenzfestem Isolationsmaterial befestigt.

Mittels eines verstellbaren Wandabschnittes 11 aus Metall kann der Hohlleiterquerschnitt stetig verkleinert werden. Das Dielektrikum im Bereich des Fensters erhält auf diese Weise eine keilförmige Gestalt, die der in Fig. 1 und 2 dargestellten Form entspricht. Der Stellwinkel W wird am besten empirisch festgelegt. Er soll so groß sein, daß das Plasma am Ende des Austrittsfensters 7 die gleiche Intensität wie am Anfang erreicht. In der Regel liegt der Stellwinkel W etwa bei 5°. Ist der Winkel nicht optimal eingestellt, so ist das Plasma nach dem einen oder dem anderen Ende des Austrittsfensters verschoben. Modensprünge lassen sich durch eine Parallelverschiebung des verstellbaren Wandabschnittes 11 ausschließen. Raum 12 ist funktionslos.

Bei einer weiteren (nicht dargestellten) Ausführungsform ist anstelle des Wandabschnittes 11 das Austrittsfenster geneigt zur Längsachse des Hohlleiters angeordnet, so daß es wiederum einen keilförmigen Raum abschließt.

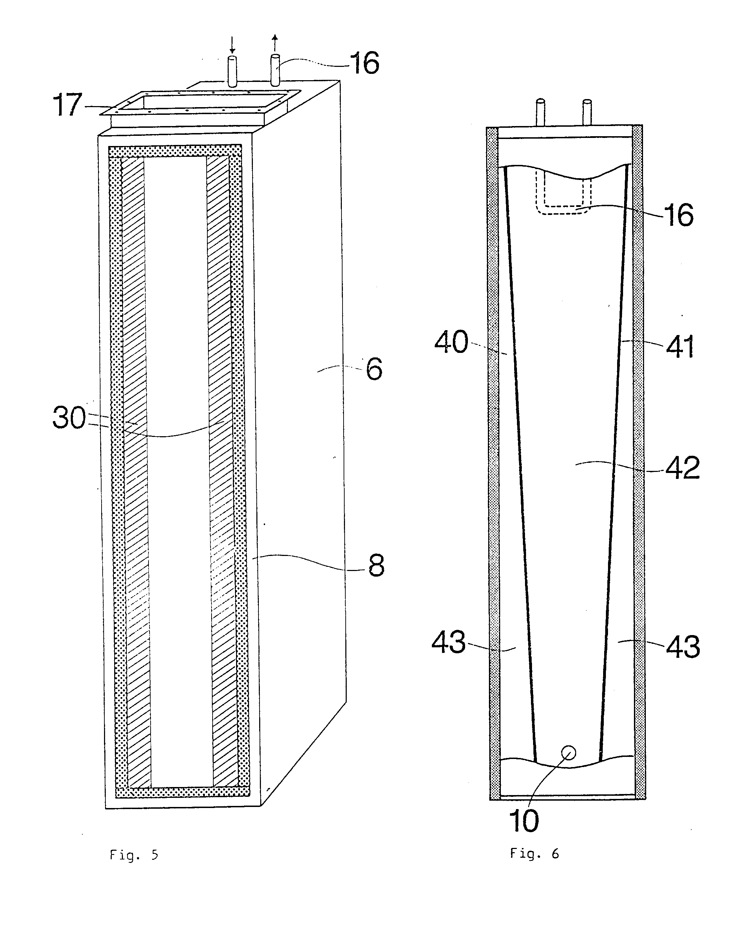

Der Hohlleiterquerschnitt kann auch entsprechend Fig. 6 durch schräggestellte Wandabschnitte 40, 41 verjüngt sein, wobei sich die in Fig. 3 dargestellte Keilform ergibt. Die Räume 43 bleiben funktionslos.

Wenn das Plasma schmäler als die Breite des Fensters sein soll, kann dieses durch Metallblenden 30, gegebenenfalls in Form einer Metallbeschichtung des Fenstermaterials, auf die gewünschte Breite verkleinert werden (Fig.5). Der Innenraum 14 des Hohlleiters kann anstatt eines Gases mit einem massiven, pulverförmigen oder flüssigen Dielektrikum gefüllt sein. Geeignet sind beispielsweise Kunststoffe, wie Polymethylmethacrylat oder Polytetrafluorethylen. Der entsprechend Fig. 1 bis 3 geformte keilförmige Kunststoffkörper wird bis auf die Ausstrahlöffnung mit Metall belegt, mit einem vakuumdichten Hochfrequenzflansch 17 zur Einkopplung der Mikrowellenstrahlung versehen und in die Vakuumkammer eingesetzt. Um eine nachteilige Auswirkung des Plasmas auf empfindliche Dielektrika zu vermeiden, kann der freiliegende Bereich, der das Austrittsfenster bildet, mit einem plasma- und hochfrequenzresistenten Werkstoff, wie z.B. DURAN$^{(R)}$-Glas, belegt werden.

Am schmalen Ende des Dielektrikums befindet sich zur Absorption der Reststrahlung vorzugsweise eine angepaßte Last 23. Sie kann z.B. aus wasserführenden, verschlossenen Kanälen in dem Dielektrikum bestehen.

## Patentansprüche

1. Mikrowellenstrahler zur Erzeugung eines Strahlungsfeldes mit einer Längenausdehnung von mehreren Wellenlängen, enthaltend eine Mikrowellen-Strahlungsquelle und einen Mikrowellenhohlleiter aus Metall, der mit einem Dielektrikum gefüllt ist und ein Fenster mit einer Längenausdehnung von mehreren Wellenlängen für den Austritt der Mikrowellen-Strahlung aufweist,

   dadurch gekennzeichnet,

   daß der das Dielektrikum umschließende Querschnitt des Hohlleiters bzw. das Dielektrikum im Bereich des Fensters mit zunehmender Entfernung von der Mikrowellen-Strahlungsquelle stetig abnimmt und/oder die Dielektrizitätskonstante des Dielektrikums zunimmt.

2. Mikrowellenstrahler nach Anspruch 1, dadurch gekennzeichnet, daß das Fenster über seine Längenausdehnung eine im wesentlichen gleichbleibende Breite hat.

3. Mikrowellenstrahler nach Anspruch 1 oder 2, dadurch gekennzeichnet, daß das Dielektrikum ein Gas, insbesondere Luft, mit einem Druck von mindestens 0,01 bar ist, und daß das Fenster mit einer für die Mikrowellen-Strahlung durchlässigen Scheibe verschlossen ist.

4. Mikrowellenstrahler nach Anspruch 1 oder 2, dadurch gekennzeichnet, daß das Dielektrikum aus einem für die Mikrowellenstrahlung durchlässigen Kunststoff besteht.

5. Mikrowellenstrahler nach Anspruch 4, dadurch gekennzeichnet, daß der Kunststoff Polymethylmethacrylat oder Polytetrafluorethylen ist.

6. Mikrowellenstrahler nach einem oder mehreren der Ansprüche 1 bis 5, dadurch gekennzeichnet, daß am Ende des Hohlleiters ein Mikrowellenabsorber angeordnet ist.

7. Mikrowellenstrahler nach Anspruch 6, dadurch gekennzeichnet, daß der Mikrowellenabsorber aus Wasser besteht.

Fig. 1

25

14

|←a→|

Fig. 2

↓P    25

z

α

S1 dP
S2 P2

Sn : Pn

23

25    Fig. 3

7

14

|←b→|

Fig. 4

Fig. 5

Fig. 6

# EUROPÄISCHER
# RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y,A | EP-A-0 183 561 (FUJITSU LTD.)<br>* Zusammenfassung; Figuren 8, 9 *<br>* Seite 14, Zeile 34 - Seite 15, Zeile 8 * *idem *<br>− − − | 1,2,3 | H 05 H 1/46 |
| Y,A | US-A-4 518 967 (WESTERMAN)<br>* Zusammenfassung; Figur 1 *<br>* Spalte 3, Zeilen 41 - 47 * *idem *<br>− − − | 1,4 | |
| A | US-A-4 512 868 (FUJIMURA ET AL.)<br>* Spalte 6, Zeilen 9 - 13; Figur 8 *<br>− − − − − | 6,7 | |

**RECHERCHIERTE
SACHGEBIETE (Int. Cl.5)**

H 05 H
H 01 J

Der vorliegende Recherchenbericht wurde für alle Patentansprüche erstellt

| Recherchenort | Abschlußdatum der Recherche | Prüfer |
|---|---|---|
| Berlin | 12 Dezember 91 | DANIELIDIS S |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
  nach dem Anmeldedatum veröffentlicht worden ist
D : in der Anmeldung angeführtes Dokument
L : aus anderen Gründen angeführtes Dokument
-----------------------------------------------------
& : Mitglied der gleichen Patentfamilie,
  übereinstimmendes Dokument